# EUROPEAN PATENT SPECIFICATION

(11) **EP 0 543 331 B1**
(45) Date of publication and mention of the grant of the patent: **18.09.1996**
(21) Application number: 92119617.6
(22) Date of filing: 17.11.1992
(51) Int. Cl.: H05K 3/46, H01L 23/538

(54) **Polyimide multilayer interconnection board and method of making the same**
Mehrschichtige Leiterplatte aus Polyimid und Verfahren zur Herstellung
Plaquette de circuits multicouche de polyimide et son procédé de fabrication

(30) Priority: 18.11.1991 JP 301430/91; 20.11.1991 JP 304755/91
(43) Date of publication of application: 26.05.1993
(73) Proprietor: NEC CORPORATION, Tokyo (JP)
(72) Inventor: Kimbara, Kohji, c/o NEC Corporation, Tokyo (JP)
(74) Representative: VOSSIUS & PARTNER

(56) References cited:
- EP-A- 0 379 736
- US-A- 4 812 191

## Description

The present invention relates to a polyimide multilayer board having interconnected multiple layers using a polyimide resin for interlayer insulation on a ceramic substrate or a hard organic resin substrate, and also to a method of making the same, wherein, in particular, the electrical connection between the interconnected layers is improved.

As an interconnection board loading an LSI chip, a multilayer printed interconnection board has conventionally been in use. The multilayer printed interconnection board has an arrangement in which a plurality of core members comprising a copper-clad laminate is mutually connected by using a prepreg as an adhesive agent. Such a polyimide multilayer interconnection board can be made by overlapping the core member and the prepreg sheet one after another to integrate by applying a heat press. The electrical connection between the laminates is carried out by, after the core member and the prepreg sheet are integrated, forming a through hole therethrough by drilling to copper the inner wall of the through hole.
In addition, recently, as an interconnection board intended for use in a large-scale computer, of which a higher wiring density is required than of the foregoing multilayer printed interconnection board, one in which a polyimide resin layer is disposed to use for interlayer insulation has come into use.

A conventional method of making this polyimide/ceramic multilayer interconnection board has comprised steps of applying a polyimide precursor varnish on the ceramic substrate and drying the same to form a viahole through this applied film (a step of forming a polyimide resin insulating layer) and forming interconnected layers utilizing a photolithography, vacuum deposition and a plating process, and this series of processes has been repeated depending on the number of the laminates to form the polyimide interconnected multiple layers.

Besides the foregoing method, one has also been available in which a wiring pattern is formed on the polyimide sheet and the sheet is registered on the ceramic substrate to sequentially laminate under pressure one after another to form a multilayer interconnection board. This method, which forms a signal layer for each sheet, allows defect-free sheets to be selectively laminated lending itself to increasing the yield more than according to the foregoing successive laminating method.

However, width the foregoing multilayer printed interconnection board, since the electrical connection between the laminates is achieved by the through hole formed by drilling, it is impossible to form a fine through hole, which causes the number of interconnections which can be molded between the through holes to be limited. Further, a single through hole becomes necessary to connect each two adjacent laminates and, as the number of laminates is increased, the capacity with which to accommodate the signal lines is reduced making it difficult to form a multilayer printed interconnection board of high density.

In addition, with the conventional method, it is necessary to repeatedly carry out each process of applying the polyimide precursor varnish on the ceramic substrate, drying, forming the viahole and curing by the number of times corresponding to the number of laminated polyimide insulating layers. Therefore, it takes an extremely amount of time to laminate the multiple layers. Still more, since the process of forming the polyimide insulating layer is repeatedly carried out, the thermal stress resulting from the curing process conducted over a great number of times is applied to the polyimide resin at the lower portion of the interconnected multiple layers, which has caused deterioration of the polyimide resin. Still further, because of the successive laminating system, with this polyimide multilayer wiring layer, it is difficult to improve the production yield.

Also, when the polyimide multilayer interconnection board is made by laminating the sheet one by one, which was developed in order to improve the production yield, since the sheet is successively laminated one by one, the thermal stress is applied to the lower layers of the polyimide resin as its number of layers is increased still causing the deterioration of the polyimide resin and an increase of the number of man-days for making the substrate.

Accordingly, it is an object of the present invention to solve these problems as above and to provide an improved polyimide multilayer interconnection board and a method of making the same, which allows the polyimide multilayer interconnection board of high quality and high density to be formed in a small number of man-day and with a high yield.

According to the present invention, there is provided a method of making a polyimide multilayer interconnection board providing a interconnected multiple polyimide layers provided on a flat substrate comprising:
(a) forming interconnected multiple polyimide layers on the substrate taking a laminate comprising a plurality of interconnected layers as one block;
(b) forming a viahole reaching the line layer internal to the laminate through the surface of the uppermost layer of the block;
(c) providing a metallic bump electrically connected to the line layer within the viahole to form a first subassembly;
(d) forming interconnected multiple polyimide layers on a hard substrate taking a laminate comprising a plurality of line layers as a single block;
(e) forming a viahole reaching the line layer internal to the laminate on the surface of the uppermost layer of the foregoing block;
(f) providing a metallic bump electrically connected to the foregoing line layer within the foregoing viahole to form a second subassembly;
(g) at least either one of the metallic bump of the first subassembly and the metallic bump of the second subassembly being made of a solder;
(h) overlapping the first and second subassemblies so that their the metallic bumps come in contact with each other;
(i) with the two overlapped subassemblies forced against each other, heating to a temperature enough to fuse the metallic bump made of the solder and, then, cooling it down to electrically connect the contacting metallic bumps while coupling two blocks together;
(j) removing a flat sheet of the first subassembly;
(k) forming a viahole reaching the line layer internal to the laminate through the surface exposed by removing the flat sheet;
(l) repeating the foregoing procedures (a) to (c) to form another first subassembly;
(m) coupling the another first subassembly resulting from the foregoing (l) on the surface exposed through the foregoing procedure (k) in the same manner as in the foregoing processes (h) and (i); and
(n) repeating the foregoing processes (j) through (m) to laminate the desired number of line layers.

According to a preferred embodiment, at least one of the metallic bumps comprises multiple plated layers each comprising a solder. These multiple plated layers may comprise a gold-plated layer and a tin plated layer each alternately disposed. At least one of the metallic bumps may take the form of a solder pool for filling the viahole.

According to another preferred embodiment of the present invention, the polyimide resin used for each block has a glass transition point, and two adjacent blocks are connected by the self-adhesiveness of the polyimide resin which is developed as they are heated to a temperature exceeding the glass transition temperature. Or they are connected by means of an adhesive agent applied on the surface of each block.

According to the present invention, in a polyimide multilayer interconnection board providing a plurality of polyimide layers, on whose both surfaces a plurality of line layers is provided on the substrate, the polyimide layers comprises a predetermined number of blocks, and the line layer of each block is electrically connected to that of another adjacent block via a plurality of metallic bumps, at least one of the two connected metallic bumps being made of a solder.

In consequence, according to the present invention, the following advantages can result as compared with the foregoing prior art.
(1) The through hole, which has been necessary with the conventional multilayer printed interconnection board, becomes unnecessary while a high accommodatability of the signal lines and an interconnection system having a great number of layers and a high density can be achieved because a fine wiring pattern can be formed at the signal line layer portion.
(2) Since the foregoing method comprises only a step of forming a laminate including a plurality of line layers, it is possible to prevent the thermal deterioration caused by curing the polyimide resin many times.
(3) According to the conventional polyimide multilayer interconnection board made by the successive laminating process, if any defect takes place during its manufacturing process, it cannot held being discarded including even its lower line layer portion, which has been formed so far, thus causing the production yield to be remarkably reduced as the number of the signal line layers to be made is increased. In contrast, according to the polyimide multilayer interconnection board of the present invention, since the line layer can be subjected to electrical inspection for each laminate block including the plurality of line layers, it can be selectively laminated with acceptable blocks, which lends itself to suppressing the reduction of the production yield as occurs as the number of the signal line layers is increased.
(4) In the conventional polyimide multilayer interconnection board made by the successive laminating process, its manufacturing period of time has increased proportional to the number of the line layers to be made. Meanwhile, according to the method of the present invention, since it comprises only a period of time in which the plurality of laminate blocks including the line layer is made and a period of time in which the laminate blocks are adhered to each other, the number of man-days necessary to make the multilayer interconnection board can be greatly shortened.

Fig. 1 is a cross-sectional view of a polyimide multilayer interconnection board according to one embodiment of the present invention;
Fig. 2 is a cross-sectional view illustrating how a first subassembly of the polyimide multilayer interconnection board of Fig. 1 is formed;
Fig. 3 is a cross-sectional view illustrating how a second subassembly of the polyimide multilayer interconnection board of Fig. 1 is formed;
Fig. 4 is a cross-sectional view illustrating how the first and second subassemblies are combined to form the polyimide multilayer interconnection board of Fig. 1;
Fig. 5 is a cross-sectional view illustrating how the polyimide multilayer interconnection board is made according to another embodiment of the present invention;
Fig. 6 is a cross-sectional view of the polyimide multilayer interconnection board according to the another embodiment of the present invention;
Fig. 7 is a cross-sectional view of the polyimide multilayer interconnection board according to a still another embodiment of the present invention;
Fig. 8 is a cross-sectional view illustrating how the polyimide multilayer interconnection board of Fig. 7 is made;
Fig. 9 is a graphic view illustrating the variation in the DSC values between before a solder pool is heated in the process of Fig. 8; and
Fig. 10 is a graphic view illustrating a differential scanning calorimetry (DSC) after the solder pool is heated in the process of Fig. 8.

Next, the polyimide multilayer interconnection board according to an embodiment of the present invention is hereinafter described in detail with reference to the accompanying drawings.

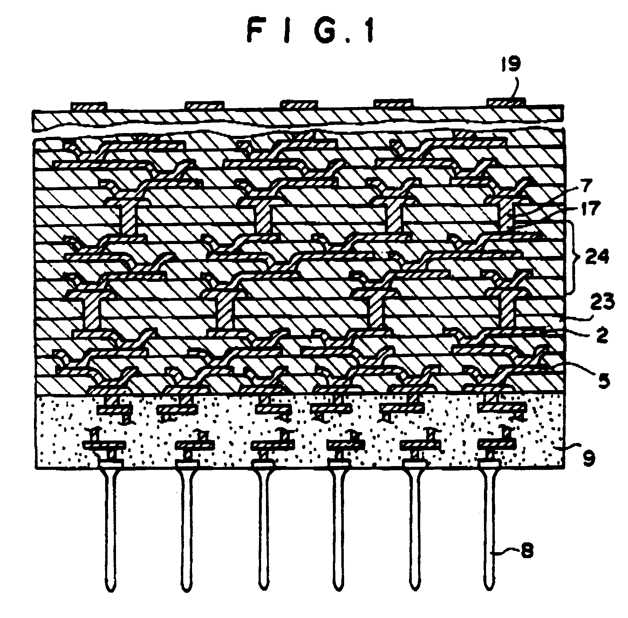

Fig. 1 illustrates a polyimide multilayer interconnection board according to the embodiment of the present invention, which comprises a substrate 9 made of ceramic or hardening organic resin, a polyimide signal line multilayer assembly provided on its one surface, that is, the front surface, and a plurality of pins 8 each for feeding I/O signals and the power supply, which are implanted into its other surface, that is, the rear surface. In this embodiment, the substrate 9 is made of alumina ceramic, within which an internal line layer 9a made of a molybdenum metal is embedded.

In the foregoing embodiment, the polyimide multilayer assembly provided on the substrate 9 is formed by laminating four blocks 24 each including a set of signal line layers 5 and a single grounding/connecting layer 2. Each of the signal line layers 5 is made of, for example, a gold-plated line having the width of 25 microns and the thickness of 7 microns. As for the signal lines, the line taken in the X direction and the line taken in the Y direction forms a single group, and the upper and lower portions of each group are sandwiched by the grounding line layer to adjust the impedance and reduce the crosstalk noise. In this embodiment, the thickness of the film between each line layer equals 20 microns.

At the uppermost layer of the formed polyimide multilayer interconnection board, a connecting pad 19 for soldering the LSI chip is formed by coppering.

The reference numeral 23 denotes a polyimide layer. The polyimide resin forming this layer 23 has a glass transition point. In this invention, any polyimide, whether it be non-photosensitive or photosensitive, can be used. As examples of suitable non-photosensitive polyimide, PIQ, PYRALYN, SEMICOFINE or the like (each commercially available from Hitach Kasei, Du Pond and Toray respectively in that order) can be enumerated and, as the photosensitive polyimide, PL-1200, Pl-2702D, PHOTONICE and PIMEL (each commercially available from Hitachi Kasei, Du Pond, Toray and Asahi Kasei respectively in that order) can be enumerated.

Each block 24, when finished, is subjected to the electrical inspection to select only the acceptable ones.

The electrical connection between each block 24 is achieved by fusing metallic bumps 7 and 17 together, the bumps 7 and 17 being preferably made of a gold-tin alloy or a nickel-gold achieved by plating gold On the nickel. The size of the metallic bump is, for example, 50 through 500 microns in width and length and 10 through 50 microns in thickness.

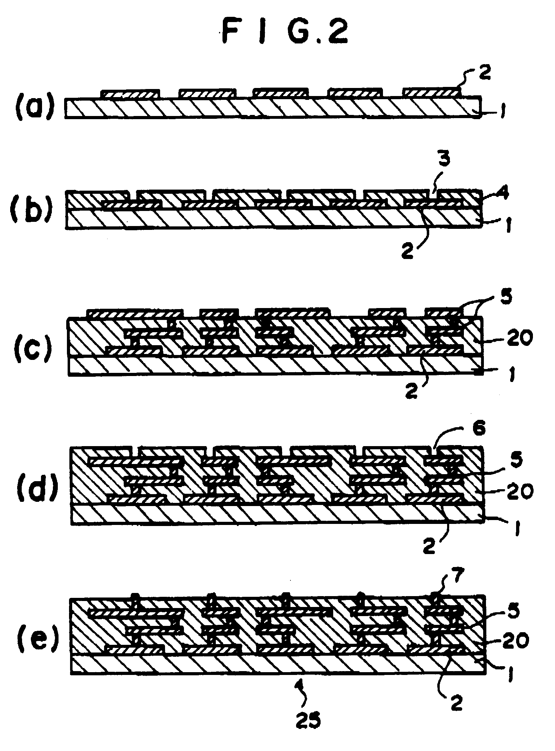

A method of making the polyimide multilayer interconnection board of Fig. 1 is hereinafter described with specific reference to Figs. 2 through 5.

First, a set of signal line layers and a single grounding/connecting layer are formed on a flat sheet made of aluminum (hereinafter referred to as "aluminum sheet") in accordance with the following procedures.

Step 1 (Fig. 2(a)): An electrically conductive substance is provided on an aluminum sheet 1 in a desired pattern in accordance with the lithography using a photoresist, and subsequently the gold is electrolytically plated on the surface of the resulting layer to form a grounding/connecting line layer 2.

Step 2 (Fig. 2(b)): A photosensitive polyimide varnish is applied on the aluminum sheet 1 on which the grounding/connecting layer 2 is formed in the process 1, and is then exposed and developed. Subsequently, it is cured to form a varnish layer 4 having a viahole 3 in position.

Step 3 (Fig. 2(c)): plural pairs of signal line layers 5 are formed by using a photosensitive polyimide 20 for interlayer insulation. These layers 5 can be formed by forming the signal line layers in the same manner as when the grounding/connecting layer 2 is formed in the process 1 and forming a layer for insulating between the signal layers in the same manner as when the insulating layer is formed in the process 2.

Step 4 (Fig. 2(d)): A polyimide varnish is applied on the signal line layer 5 formed in the process 3 and is exposed and developed to form a viahole 6 in position before cured. As the polyimide varnish, a photosensitive polyimide resin having a glass transition point of about 270 degrees Centigrade is used.

Step 5 (Fig. 2(e)): A metallic bump 7 is formed at the uppermost layer of the multiple line layers 5 formed in the process 4 within a viahole 6 electrically connected to the multiple line layers formed in the processes following this one. The metallic bump 7, after the sheet is patterned by the photolithography using the photoresist, the metallic bump 7 is provided by first electrolytically forming a tin plating of thickness of 3 microns and then forming a multilayer plating with the tin plating and the gold plating. The multilayer plating comprising the gold and the nickel is fused by the heat evolving in the following process adhering the polyimide layer to be turned into a gold-tin alloy solder. Preferably, the ratio between the film thicknesses for the gold and the tin is selected to be 10 : 7 so that their weight ratio becomes 4 : 1. Therefore, each film thickness is selected so that the gold plating accounts for 1 micron and the tin plating accounts for 0.7 microns, and a total of six layers (their total thickness amounts to 10.2 microns) is formed. The nickel plating serves as a layer for preventing the solder from diffusing toward the gold line layer.

A first subassembly 25 as shown in Fig. 2(e) is formed according to the foregoing procedures. On the other hand, aside from the first subassembly 25, a second subassembly is formed in accordance with the following procedure, with a set of signal line layers and a grounding/connecting layer sandwiching them formed on a ceramic substrate having I/O pins on the rear surface.

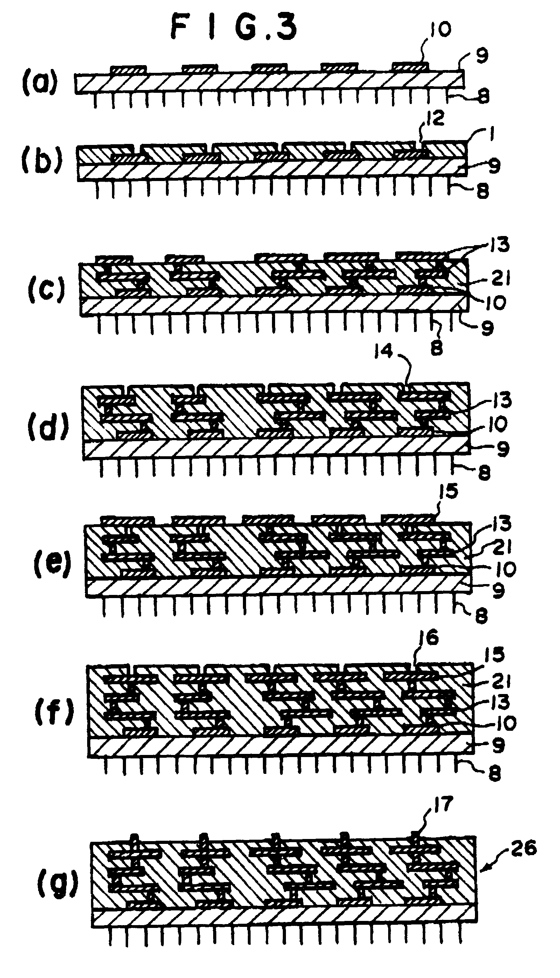

step 6 (Fig. 3(a)): on the ceramic substrate 9 on the rear surface of which a plurality of pins 8 intended for feeding I/O signals and the power supply is implanted, the grounding/connecting layer 19 is patterned by the lithography using the photoresist and is electrolytically plated with gold to form the grounding/connecting line layer.

Step 7 (Fig. 3(b)): a photosensitive polyimide varnish 11 is applied on the ceramic substrate on which the grounding/connecting layer was formed in the process 6, and is exposed and developed to form a viahole 12 in position before the varnish is cured.

Step 8 (Fig. 3(c)): a set of signal line layers 13 is formed by using the photosensitive polyimide for interlayer insulation. At this time, the signal line layer is formed in the same manner as when the grounding/connecting layer was formed in the process 1, and the layer for insulating between the signal line layers is formed in the same manner as when the insulating layer was formed in the process 2.

Step 9 (Fig. 3(d)): the photosensitive polyimide varnish is applied on the signal line layer formed in the process 8, and is exposed and developed to form a viahole in position before curing.

Step 10 (Fig. 3(e)): the grounding/connecting layer 15 is formed on the polyimide layer formed in the process 9 in the same manner as in the process 6.

Step 11 (Fig. 3 (f)): A polyimide layer having a viahole 16 formed is formed on the second grounding/connecting layer 15 in the same manner as used in the process 6.

Step 12 (Fig. 3(g)): A metallic bump 17 is formed on the polyimide layer formed in the process 11. It may be formed in the same manner as in the foregoing process 5. A second subassembly 26 is formed through the processes 6 through 12.

According to the present invention, the polyimide multilayer interconnection board having the arrangement of Fig. 1 is mad by combining the first assembly 25 of Fig. 2 (e) and the second subassembly 26 of Fig. 3 (g) so that the metallic bumps 7 and 17 come in contact with each other and fusing both together. This joining process is hereinafter described.

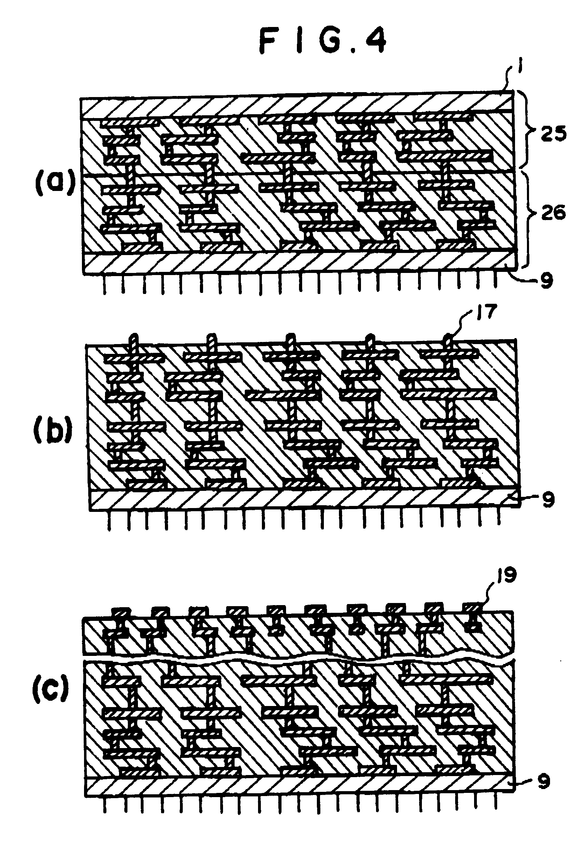

Step 13 (Fig. 4 (a)): After registered with each other, the first subassembly 25 formed through the processes 1 through 5 and the second subassembly 26 formed through the processes 6 through 12 are overlapped to be heated in this state. The heating temperature is set to a higher temperature than the melting point of at least one of the metallic bumps 7 and 17 with the result that the contacting polyimide films are softened to be integrated while the metallic bumps 7 and 17 are fused with each other.

In the present invention, at least one of the metallic bumps 7 and 17 is made of a solder. The preferred solders are a gold-tin solder, tin-lead solder and a tin-lead-bismuth series low-temperature solder. Most preferably, these solders are each made of a plated multilayer obtained by alternately laminating the plated layers constituting the solder. If one of the metallic bumps is made of a metal or alloy other than the solder, then the solder is preferably made including the same metal as the metal of this bump.

When the subassemblies 26 and 27 are heated, the plated multilayer is fused to be turned into a solder alloy, and after the solder is cooled and solidified, two subassemblies end up in being electrically connected.

For applying pressure and heating, an autoclave type vacuum press unit, for example, may be used. Nitrogen gas is used therein as the pressuring gas, and the two assemblies are pressed against each other at 3 kg/cm2 up to a temperature of 250 degrees Centigrade and at 14 kg/cm2 up to the substrate temperature of 250 through 350 degrees Centigrade respectively. At this time, the substrate is sealed by using a polyimide film placed on the platen and, by connecting a vacuum pump, the interior of the unit is set to a vacuum condition of below 10 Torr, in which process the two subassemblies may finally be coupled.

Step 14 (Fig. 4 (b)): the aluminum sheet portion of the adhered substrate is immersed within a 16 % hydrochloric acid aqueous solution to dissolve and remove the aluminum sheet.

Step 15: a photosensitive polyimide varnish is applied on the grounding/connecting line layer 2 of the process 1, which is exposed anew in the process 14, and is exposed and developed to form a viahole in position before cured.

Step 16: a metallic bump 17 made of a gold-tin solder is formed on the polyimide layer formed in the process 15. It may be formed in the same manner as in the process 5.

Procedure 17 (Fig. 4(c)): Another polyimide line layer formed in the processes 1 through 5 is laminated for integration on the polyimide line layer laminate formed in the processes 1 through 16 in the same manner as in the processes 13 through 16.

Step 18: The processes 1 through 17 are repeated until the number of the line layers reaches a desired number (eight in this example).

Step 19: finally, a connecting electrode layer 19 is formed to connect the wirings of the multilayer interconnection board and the LSI chip. This process is carried out by, after the process 18 is completed, forming a connecting electrode pad 19 for soldering the bump of a chip carrier sealing the LSI chip on the polyimide layer formed in the process 15. Preferably, a tin-lead eutectoid solder is used as the solder for connecting the bump of the LSI chip carrier and the connecting electrode pad 19 while the connecting electrode pad 19 is formed of a copper plating which is unlikely to absorb the tin-lead solder.

If the forgoing method according to the present invention is adopted, with the polyimide multilayer interconnection board of Fig. 1, the number of curing processes necessary for this method equals 3 as compared with the same (12) necessary for the conventional successive laminating method, which shows that the former equals one fourth of the latter.

Further, according to the method of the present invention, since the number of necessary curing processes remains 3 regardless of the number of formed line layers, the more the number of signal line layers is formed, the greater its effect is increased.

Still further, according to the present invention, it is possible to greatly improve the production yield as compared with that for the conventional methods. If the polyimide multilayer interconnection board of Fig. 1 is taken by way of example, then the yield is as follows.

Assuming that the yield for each layer in the processing for forming the signal layer or ground line = 95 % and that the yield for one process of adhering the laminate block = 95 %, the yield according to the conventional successive laminating system turns out to be 0.51 (= (0.95)13 because the number of formed line layers equals 13 (= 8 signal layers + 5 ground layers). Thus the total yield results in 51 %.

On the other hand, for the production yield according to the present invention, one for a single laminate block is (0.95)3 = 0.86 in view of 3 layers for the arrangement of a single laminate block (= 2 signal layers + 1 ground layer), and one for three processes of adhering the laminate block is 0.86 (-(0.95)3) in view of 3 for the number of processes of adhering the laminate block. Thus the total production yield results in 0.86 x 0.86 = 0.74 (74 %).

That is, according to the present invention, the production yield is improved as much as about 23 % under the same condition as compared with the same according to the conventional method. It will be apparent from the foregoing calculations that the advantage of the present invention becomes the greater the more the number of the signal line layers is increased.

Furthermore, as another advantage, the present invention allows the time or the number of man-days necessary to produce the polyimide multilayer interconnection board to be greatly shortened. With the polyimide multilayer interconnection board, assuming that the number of man-days necessary to form a single line layer be 1, that that of man-days necessary to form a single insulating layer be 1 and that that of man-days necessary to form carry out a single process of adhering the laminate block be 1, the man-days necessary for the conventional successive laminating system results in 26 (= 13 + 13) because the number of the formed line layers is 13 (= 8 signal layers + 5 ground layers), the number of man-day necessary to form the line layer is 13, the number of the formed insulating layers is 13 and the number of man-days necessary to form the insulating layer is 13.

In contrast, according to the method of the present invention, the number of man-days results in 9 (= 6 + 3) and can be shortened as much as 65 % as compare with the conventional one because the number of line layers for a single laminate block is 3 (= 2 signal layers + 1 ground layer), the number of insulating layers for a single laminate block is 3 (= 2 signal layers + 1 ground layer), the number of man-days necessary to form a single laminate block is 6, the number of processes of adhering the laminate blocks is 3 and the number of man-days necessary to carrying out the adhering process three times is 3.

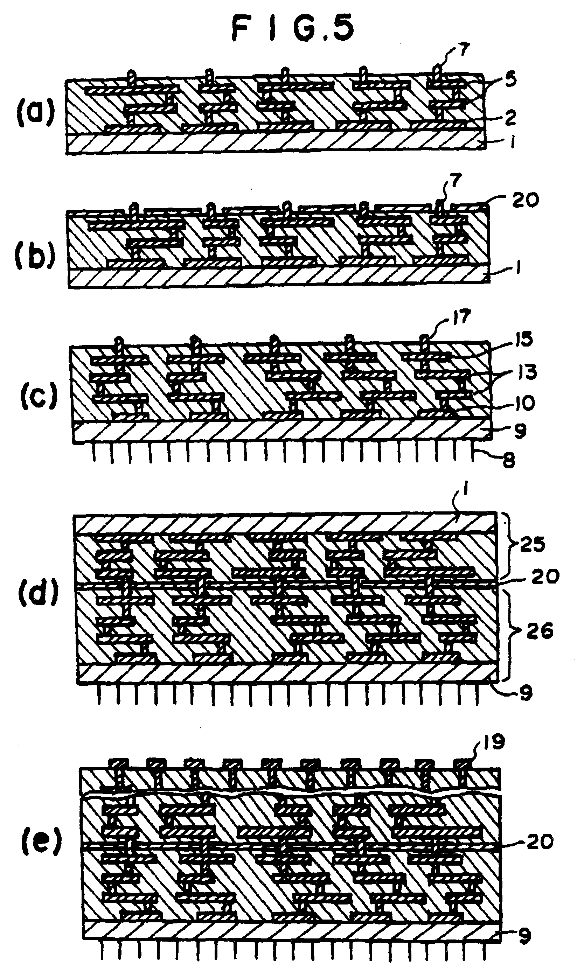

Fig. 5 illustrates a second embodiment of the method according to the present invention in the order of the processes carried out. The arrangement of the polyimide multilayer line layer portion made in this embodiment is the same as that of the embodiment of Fig. 1. As the polyimide resin, a photosensitive polyimide of low thermal expansion having no glass transition point (for example, TL (E) X1 commercially available from Asahi Kasei) is used and, as the adhesive agent, a maleinimide resin, which can be molten and hard, is used and, as the line metal, copper is used. Incidentally, photosensitive radicals of the polyimide which is used in this embodiment is unlikely to react with the metallic copper, and therefore, the line layer can be formed with only the copper.

First, a set of signal line layers and a single ground/connecting layer are formed on the aluminum sheet in the following manner.

Step 1 (Fig.5 (a)): the ground/connecting line layer is patterned on the aluminum sheet 1 by the photolithography using the photoresist to electrolytically copper to form the ground/connecting line layer 2.

Step 2: A photosensitive polyimide varnish is applied on the aluminum sheet on which the ground/connecting layer 2 is formed in the process 1, and is exposed and developed to form a viahole in position for curing.

Step 3: a set of signal line layers 5 is formed by using the photosensitive polyimide for interlayer insulation. At this time, the signal line layer is formed in the same manner as when the ground/connecting layer was formed in the process 1, and a layer for insulating between the signal line layers is formed in the same manner as when the insulating layer was formed in the process 2.

Step 4: a polyimide varnish is applied on the signal line layer formed in the process 3, and is exposed and developed to form a viahole in position for curing.

Step 5: a connecting bump 7 is formed in the uppermost layer of the multilayer line layer which was formed in the process 4 at the position it is electrically connected to the multilayer line layer which will be formed in the processes following this process. As the connecting bump, a tin-lead-bismuth series low-temperature solder is used. The metallic bump made of the same material is formed according to the lift-off method by the lithography process using the photoresist and the tin-lead-bismuth alloy precipitating process through vacuum deposition. The film thickness of the soldered layer equals 10 microns at this time.

Step 6: As illustrated in Fig. 5 (b), a maleinimide varnish 20 is applied on the uppermost layer of the line multilayer formed in the process 5 to dry by an oven for circulating hot wind.

Step 7: The maleinimide resin 20 placed on the bump formed in the process 5 is removed. The removing process is as follows. A copper thin film layer is formed 0.5 microns on the maleimide resin other than on the bump formed in the process 5 according to the lithography process using the photolithography process using the photoresist and the process for forming the copper thin film by sputtering, and then the exposed maleimide resin is removed by the plasma etching process using oxygen gas to expose the connecting bump formed in the process 5 before the copper thin film remaining on the maleimide resin is then removed according to the wet etching process.

Next, aside from the foregoing, a set of signal line layers and a ground/connecting layer sandwiching them are formed on the ceramic substrate having I/O pins on its rear surface in accordance with the following process.

Step 8 (Fig. 5 (c)): The ground/connecting layer 10 is patterned on the ceramic substrate having the signal I/O pins and a power supply pin 8 according to the lithography using the photoresist to electrolytically copper to form the ground/connecting line layer.

Step 9: a photosensitive polyimide varnish is applied on the ceramic substrate having the ground/connecting layer 10 formed in the process 8, and is exposed and developed to form a viahole in position for curing.

Step 10: a set of signal line layers 13 is formed by using the photosensitive polyimide for interlayer insulation. At this time, the signal line layer is formed in the same manner as when the ground/connecting layer was formed in the process 1, and the layer for insulating between the signal line layers is formed in the same manner as when the insulating layer was formed in the process 2.

Step 11: a photosensitive polyimide varnish is applied on the signal line layer formed in the process 10, and is exposed and developed to form a viahole in position for curing.

Step 12: a ground/connecting layer 15 is formed on the polyimide layer formed in the process 11 in the same manner as used in the process 8.

Step 13: a polyimide layer having a viahole formed is formed on the second ground/connecting layer 15 in the same manner as in the process 11.

Step 14: a metallic bump 17 made of a tin-lead-bismuth series low-temperature solder is formed on the polyimide layer formed in the process 13. The metallic bump 17 is formed in the same manner as in the process 5. At this time, the film thickness of the soldered layer equals 10 microns.

Step 15: as shown in Fig. 5 (d), a first assembly 25, formed in the processes 1 through 7, having a connecting solder bump and a adhesive layer 20 made of maleinimide resin and a second subassembly 26 formed in the processes 8 through 14 are overlapped on the aluminum sheet after registered, to apply pressure and heat up to a temperature at which the maleimide resin fluidizes to adhere each polyimide line multilayer for fixation. At this time, the metallic bumps 7, 17 made of the low-temperature solder are fused to complete the electrical connection between the two laminates. The pressing and heating methods may be the same as ones applied in the case of Fig. 4.

Step 16: The aluminum sheet portion of the adhered substrate is immersed within a 16 % hydrochloric acid aqueous solution to dissolve and remove the aluminum sheet 1.

Step 17: a photosensitive polyimide varnish is applied on the ground/connecting line layer 2 exposed anew in the process 16, which was formed in the process 1, and is exposed and developed to form a viahole in position for curing.

Step 18: a metallic bump 7 made of a tin-lead-bismuth series low-temperature solder is formed on the polyimide layer formed in the process 17 in the same manner as in the process 5.

Step 19: The laminating process is repeated for integration until the number of the line layers attains eight and, finally, as shown in Fig. 5 (e), a connecting electrode layer 19 is formed to connect the wirings of the multilayer interconnection board and the LSI chip. This process is the same as the process 19 in the first embodiment.

Although, in this embodiment, the molten and hard type maleimide resin was used for the adhesive agent, other than that, it is also possible to use a molten type ethylene fluoride and perfluoroalkyl-perfluorovinylether copolymer.

Although, in the foregoing embodiment, the adhesive agent was applied or laminated only on the surface layer of either one of the two polyimide multilayers adhered to each other, if the roughness of the polyimide surface layer is great, then the adhesive agent may be applied or laminated on both surface layers in the same manner to reduce the effect caused by the roughness of the adhered surface.

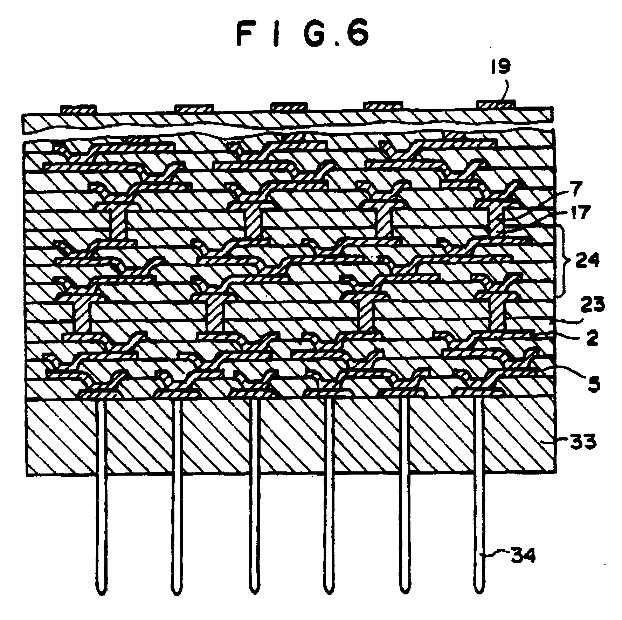

As the substrate having the signal I/O pins, in place of the ceramic substrate, a hard organic resin substrate, for example, a substrate formed of a polyimide resin or the like may be used. In this case, the signal I/O pins are implanted into the through hole formed through the polyimide resin substrate. Fig. 6 illustrates a cross-sectional view of the polyimide multilayer interconnection board using this polyimide resin substrate.

In Fig. 5, the signal I/O pin 34 is implanted into the polyimide substrate 33. Other arrangements are the same as those of the polyimide multilayer interconnection board of Fig. 1, and the same reference numeral are each assigned to the same elements. According to the multilayer interconnection board of this embodiment, it is possible to accurately align the thermal expansion coefficients of the polyimide resin substrate 33, which serves as the base, and of the polyimide multilayer having the line layer 5, and it is especially suitable for making a interconnection board of large area and of high lamination factor.

In another preferred embodiment of the present invention, the polyimide multilayer interconnection board may be arranged so that either one of the two adjacent blocks has the metallic bump and the other has the solder pool.

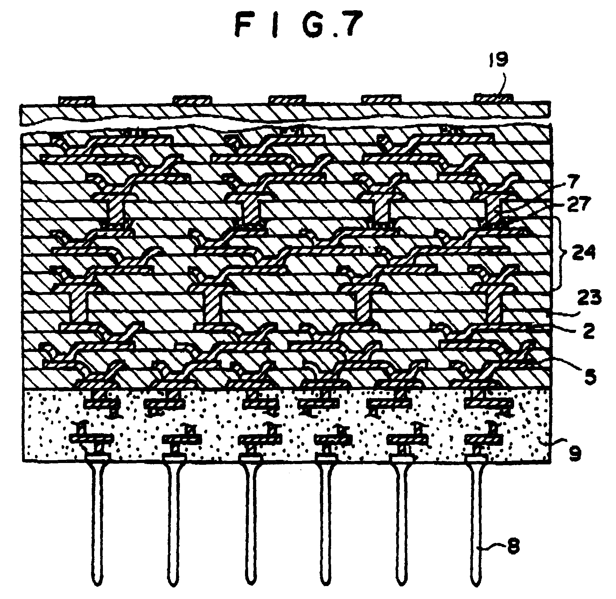

Fig. 7 illustrates the polyimide multilayer interconnection board having the solder pool according to the present invention. A ceramic substrate 9 used in this interconnection board is made of alumina ceramic. It has I/O pins 8 on the rear surface of the substrate, and has an internal line layer made of a molibdenum metal.

Since the specification of the polyimide multilayer is substantially the same as that of the polyimide multilayer interconnection board of Fig. 1, the same or similar portions are assigned with the same reference signs and their detailed description is omitted. This polyimide multilayer interconnection board differs from that of Fig. 1 in that the metallic bump 7 is provided on either one of the adjacent blocks while, in the other block, a solder pool 27 is provided.

That is, the electrical connection between each block is achieved by fusing the metallic bump 7 made of a nickel-gold material (gold is plated on the nickel plating) and the solder pool 27 formed of a multilayer plating obtained by alternately overlapping a plurality of different metals, for example, the gold-plated layer and the tin-plated layer. The solder pool is for example, 50 through 500 microns in length and width and 10 through 100 microns in depth, and the gold-nickel bump is, for example, 25 through 300 microns in width and length and 10 through 50 microns in thickness.

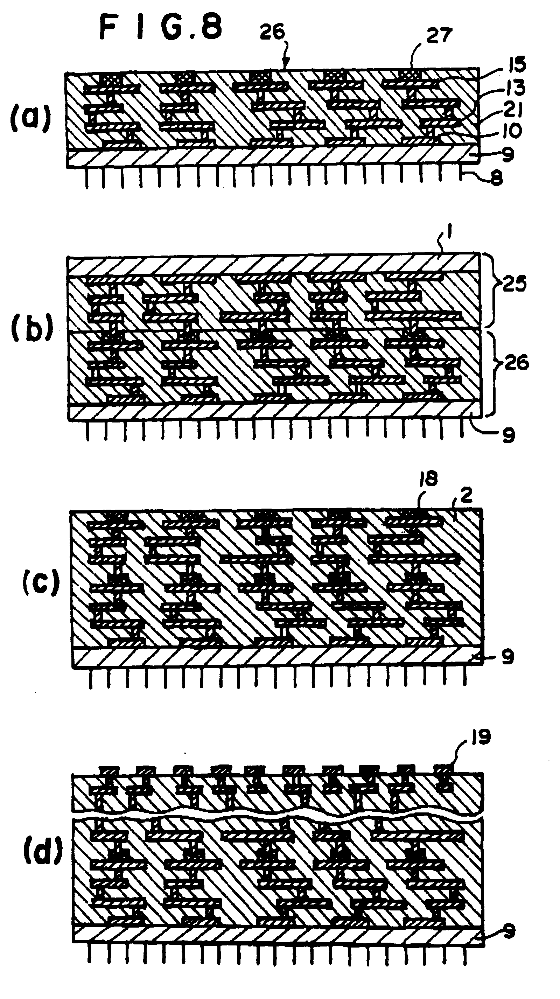

Fig. 8 illustrates a method of making the polyimide multilayer interconnection board according to the present invention in the order of the processes carried out, in which, as the polyimide resin, a photosensitive polyimide having a glass transition point of about 270 degrees Centigrade is used, and as the wired metal, gold is used.

In this method, in order to make the polyimide multilayer interconnection board of Fig. 1, a first subassembly is prepared according to the processes (a) through (e) of Fig. 2, and the steps (a) through (f) illustrated in Fig. 3 are followed without undergoing any substantial modification, through which a second assembly is prepared. The resulting second subassembly is indicated with a sign 26 in Fig. 8 (a).

In this second subassembly 26, the solder pool 27 formed of the multilayer plating connected to the signal line 15 is provided within the viahole 16 formed on the polyimide layer. This solder pool comprises at least two kinds of metal which are melted during the heating process faster than the signal line. A preferred combination of the metals is gold and tin. This gold-tin solder pool is patterned by the photolithography using the photoresist and a nickel-plated layer of proper thickness, for example, about 3 microns is formed thereon by the electrolytic plating process. Then the electrolytic tin plating and the electrolytic gold plating are alternately conducted thereon. The nickel-plated layer is provided in order to prevent the gold-tin solder from diffusing toward the gold line layer.

The solder pool comprising a multilayer plating of gold and tin is melted by the heat imparted when the polyimide layers are adhered, as will be described later, resulting in the solder of gold-tin alloy. The ratio between the gold and the tin within the solder pool is preferably 4 : 1 in terms of weight ratio, and this ratio can be achieved by setting the total ratio of their film thickness to 10 : 7. A preferred solder pool can be obtained by forming a total of six of the gold -plated layers of thickness of 1 micron and six thin-plated layers of thickness of 0.7 micron (the total film thickness of the gold-tin plated multilayer equals 10.2 microns).

The first subassembly 25 shown in Fig. 2(e) and the second subassembly 26 in Fig. 8(a) are overlapped after registered, and are pressed and heated up to a temperature exceeding the glass transition point of the polyimide resin to be adhered to each other by each polyimide film (Fig. 8(b)). When they are heated, the solder pool 27, if made of the multilayer plating of the gold and the tin, is melted at around 280 degrees Centigrade and turned into a gold-tin alloy solder, which is joined with the metallic bump 7 formed in the process 5 to achieve the electrical connection between the two subassemblies. At the same time, the gold of the metallic bump 7 becomes compatible with the gold-tin solder alloy of the solder pool 27 to thereby change the metallic composition of the solder pool 27 into a gold-tin solder richer in the gold to elevate the melting point. Therefore, even if it is heated to the same temperature in the next overlapping process, since the solder at the contact point between the already connected solder pool 27 and the bump 7 is not melted, it cannot happen that their connecting portions are undesirably separated again.

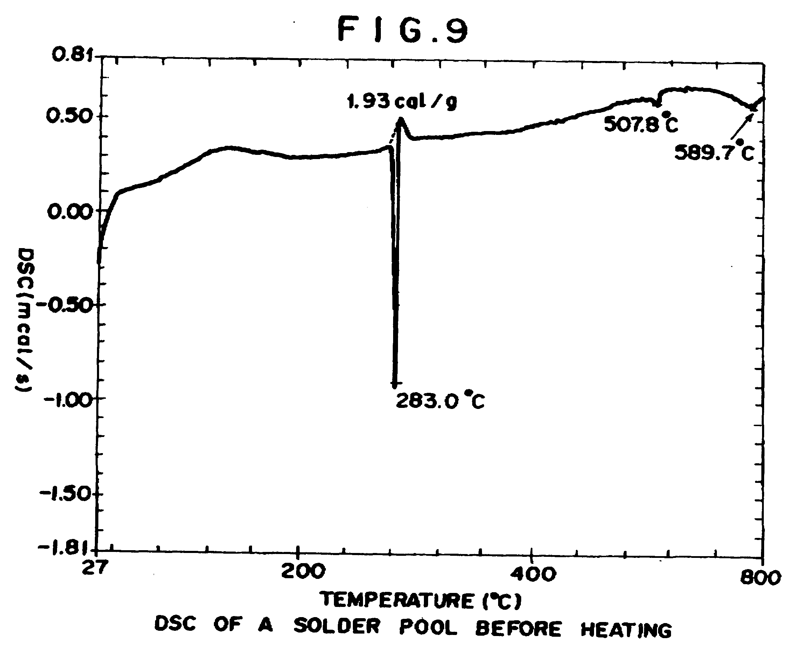

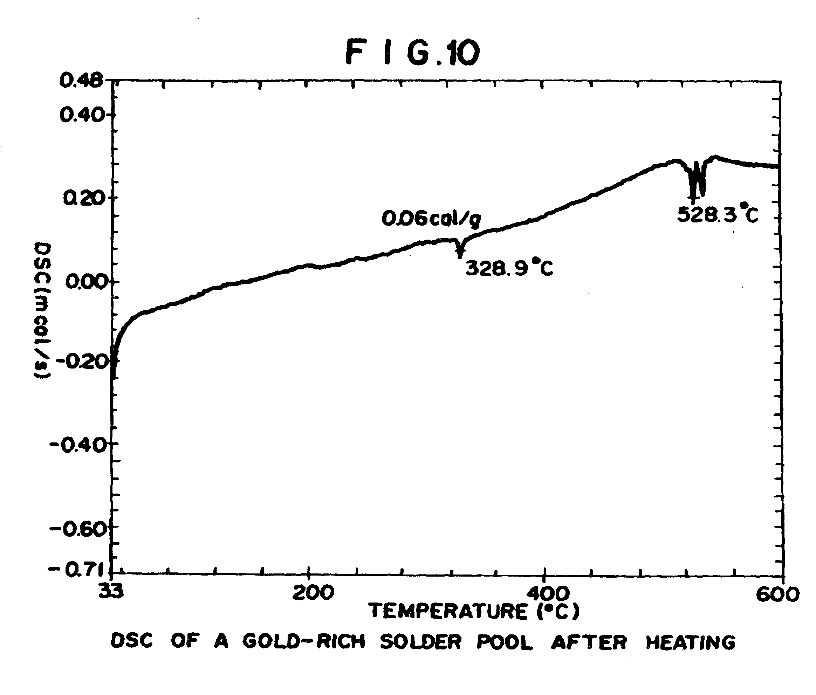

This elevation of the melting point of the solder can be confirmed according to the differential scanning calorimetry (DSC). The DSC for the solder pool 27 prior to the hating process and the DSC for the solder pool richer in gold after the heating process are each illustrated in Figs. 9 and 10 respectively. As seen from the comparison of Figs. 9 and 10, after the heating process, the peak of the melting point does not exist within the measuring range up to 600 degrees Centigrade.

After the two subassemblies 25 and 26 have been coupled, as in the already described embodiment, the sheet 1 is removed (Fig. 8(c)) and the process for coupling the first subassembly 25 is repeated by necessary times and, finally, the electrode 19 is provided (Fig. 8(d)).

As described above, according to the present invention, the polyimide multilayer interconnection board of high lamination factor and of high density can be formed in a very short period of time as compared with the conventional polyimide/ceramic multilayer interconnection board made in accordance with the conventional successive laminating system, and can be subjected to electrical inspection for each block so that only the acceptable blocks can be selected for lamination. In consequence, a high production yield an be achieved.

## Claims

1. Method of making a polyimide multilayer interconnection board providing multiple polyimide line layers provided on a flat substrate comprising the steps of:
(a) forming a polyimide line multilayer assembly taking a laminate comprising a plurality of line layers as one block on a flat sheet;
(b) forming a viahole reaching the line layer internal to the laminate through the surface of the uppermost layer of said block:
(c) forming a first subassembly by providing a metallic bump electrically connected to said line layer within said viahole;
(d) forming a polyimide multilayer assembly taking a laminate comprising a plurality of line layers as one block on hardened substrates;
(e) forming a viahole reaching the line layer internal to the laminate through the surface of the uppermost layer of said block;
(f) forming a second subassembly by providing a metallic bump electrically connected to said line layer within said viahole;
(g) at least one of said metallic bump of said first subassembly and said metallic bump of said second subassembly being made of a solder;
(h) overlapping said first and second subassemblies one over the other so that their metallic bumps come in contact with each other;
(i) with said two overlapped subassemblies forced against each other, heating them to a temperature enough to melt said metallic bumps and then cooling to electrically connect said contacting metallic bumps while coupling the two blocks;
(j) removing said flat sheet of said first subassembly;
(k) forming a viahole reaching the line layer internal to the laminate through the surface exposed by removing said flat sheet;
(l) repeating said steps (a) through (c) to form another first subassembly;
(m) coupling the another first subassembly obtained in said step (l) on the surface exposed through said step (k) in the same manner as in said steps (h) and (i); and
(n) repeating said steps (j) through (m) to laminate a desired number of line layers.

2. Method as set forth in claim 1 wherein at least one of said metallic bumps comprises multiple plated layers each made of a solder metal.

3. Method as set forth in claim 1 or 2 wherein said plated multilayer comprises alternately disposed gold-plated layer and tin-plated layer.

4. Method as set forth in claim 1, 2, or 3 wherein at least one of said metallic bumps comprises a solder pool filling said viahole.

5. Method as set forth in claim 4 wherein said metallic bump comprises the same metal as that forming said solder pool or an alloy containing this metal.

6. Method as set forth in any one of claims 1 to 5 wherein said solder pool comprises a plated multilayer.

7. Method as set forth in claim 6 wherein said plated multilayer comprises alternately disposed gold-plated layer and tin-plated layer.

8. Method as set forth in claim 6 or 7 wherein said plated multilayer comprises alternately disposed tin-plated layer and lead-plated layer.

9. Method as set forth in any one of claims 1 to 8 wherein the uppermost layer of said block comprises a polyimide resin having a glass transition point and said step (i) is carried out at a temperature exceeding the glass transition point of this polyimide resin so that, by self-adhesiveness of said polyimide resin, said blocks are coupled.

10. Method as set forth in any one of claims 1 to 9 wherein the coupling of said blocks in the step (i) is achieved by an adhesive agent applied on the surface of said each block.

11. Method as set forth in claim 10 wherein said adhesive agent comprises a molten and hard type adhesive agent.

12. Method as set forth in claim 10 wherein said adhesive agent comprises a molten type adhesive agent.

13. Polyimide multilayer interconnection board providing a plurality of polyimide layers having a plurality of line layers on their both surfaces on substrates wherein said polyimide layer comprises a predetermined number of blocks, the line layers of each block being electrically connected to the line layers of another adjacent block via a plurality of metallic bump, at least one of the two connected metallic bumps being made of a solder.

14. Polyimide multilayer interconnection board as set forth in claim 13 wherein one of the connected metallic bumps comprises a solder pool.

15. Polyimide multilayer interconnection board as set forth in claim 13 or 14 wherein said solder forming the solder pool takes the metal forming the metallic bump connected to said solder pool as one of its constituents.

16. Polyimide multilayer interconnection board as set forth in claim 14 or 15, wherein said solder pool comprises a plated multilayer.

17. Polyimide multilayer interconnection board as set forth in claim 14, 15, or 16, wherein said plated multilayer comprises alternately disposed gold-plated layer and tin-plated layer.

18. Polyimide multilayer interconnection board as set forth in any one of claims 14 to 17 wherein said plated multilayer comprises alternately disposed tin-plated layer and lead-plated layer.

## Patentansprüche

1. Verfahren zur Herstellung einer Polyimid-Mehrlagenleiterplatte mit mehreren, auf einem flachen Substrat aufgebauten Polyimid-Leiterlagen, wobei das Verfahren die folgenden Schritte aufweist:
(a) Ausbilden einer Polyimid-Mehrlagenleiterbaugruppe auf einer flachen Folie, wobei ein Laminat mit mehreren Leiterlagen als ein Block behandelt wird;
(b) Ausbilden eines Kontaktlochs, das bis zu der Leiterlage innerhalb des Laminats reicht, in der Oberfläche der obersten Lage des Blocks;
(c) Ausbilden einer ersten Baugruppe durch Anbringen eines metallischen Bondhügels, der mit der Leiterlage innerhalb des Kontaktlochs elektrisch verbunden ist;
(d) Ausbilden einer Polyimid-Mehrlagenbaugruppe auf gehärteten Substraten, wobei ein Laminat mit mehreren Leiterlagen als ein Block behandelt wird;
(e) Ausbilden eines Kontaktlochs, das bis zu der Leiterlage innerhalb des Laminats reicht, in der Oberfläche der obersten Lage des Blocks;
(f) Ausbilden einer zweiten Baugruppe durch Anbringen eines metallischen Bondhügels, der mit der Leiterlage innerhalb des Kontaktlochs elektrisch verbunden ist;
(g) wobei mindestens einer der metallischen Bondhügel der ersten Baugruppe und der zweiten Baugruppe aus einem Lot besteht;
(h) Übereinanderlegen der ersten und der zweiten Baugruppe, so daß ihre metallischen Bondhügel miteinander in Kontakt kommen;
(i) Zusammenpressen der beiden übereinandergelegten Baugruppen, Erhitzen auf eine Temperatur, die zum Schmelzen der metallischen Bondhügel ausreicht, und anschließendes Abkühlen, um die einander berührenden metallischen Bondhügel elektrisch miteinander zu verbinden, während die beiden Blöcke zusammengefügt werden;
(j) Entfernen der flachen Folie von der ersten Baugruppe;
(k) Ausbilden eines Kontaktlochs, das bis zu der Leiterlage innerhalb des Laminats reicht, in der beim Entfernen der flachen Folie freigelegten Oberfläche;
(l) Wiederholen der Schritte (a) bis (c) zur Ausbildung einer weiteren ersten Baugruppe;
(m) Verbinden der im Schritt (l) erhaltenen weiteren ersten Baugruppe mit der im Schritt (k) freigelegten Oberfläche auf die gleiche Weise wie in den Schritten (h) und (i); und
(n) Wiederholen der Schritte (j) bis (m), um eine gewünschte Anzahl von Leiterlagen zu laminieren.

2. Verfahren nach Anspruch 1, wobei mindestens einer der metallischen Bondhügel mehrere plattierte Schichten aus je einem Lotmetall aufweist.

3. Verfahren nach Anspruch 1 oder 2, wobei die plattierte Mehrschichtenstruktur abwechselnd angeordnete plattierte Gold- und Zinnschichten aufweist.

4. Verfahren nach Anspruch 1, 2 oder 3, wobei mindestens einer der metallischen Bondhügel einen Löttümpel aufweist, der das Kontaktloch ausfüllt.

5. Verfahren nach Anspruch 4, wobei der metallische Bondhügel das gleiche Metall wie der Löttümpel oder eine Legierung aufweist, welche dieses Metall enthält.

6. Verfahren nach einem der Ansprüche 1 bis 5, wobei der Löttümpel eine plattierte Mehrschichtenstruktur aufweist.

7. Verfahren nach Anspruch 6, wobei die plattierte Mehrschichtenstruktur abwechselnd angeordnete plattierte Gold- und Zinnschichten aufweist.

8. Verfahren nach Anspruch 6 oder 7, wobei die plattierte Mehrschichtenstruktur abwechselnd angeordnete plattierte Zinn- und Bleischichten aufweist.

9. Verfahren nach einem der Ansprüche 1 bis 8, wobei die oberste Lage des Blocks ein Polyimidharz mit einem Glasübergangspunkt aufweist und der Schritt (i) bei einer Temperatur ausgeführt wird, die den Glasübergangspunkt dieses Polyimidharzes übersteigt, so daß die Blöcke durch das Selbstadhäsionsvermögen des Polyimidharzes miteinander verbunden werden.

10. Verfahren nach einem der Ansprüche 1 bis 9, wobei die Verbindung der Blöcke im Schritt (i) durch einen auf die Oberfläche jedes Blocks aufgebrachten Klebstoff erzielt wird.

11. Verfahren nach Anspruch 10, wobei der Klebstoff ein härtbarer Schmelzklebstoff ist.

12. Verfahren nach Anspruch 10, wobei der Klebstoff ein Schmelzklebstoff ist.

13. Polyimid-Mehrlagenleiterplatte, die mehrere auf Substrate aufgebrachte Polyimidschichten mit jeweils mehreren Leiterlagen an ihren beiden Oberflächen aufweist, wobei die Polyimidschicht eine vorher festgesetzte Anzahl von Blöcken aufweist, wobei die Leiterlagen jedes Blocks mit den Leiterlagen eines anderen, benachbarten Blocks durch mehrere metallische Bondhügel elektrisch miteinander verbunden sind, wobei mindestens einer von zwei verbundenen metallischen Bondhügeln aus einem Lot besteht.

14. Polyimid-Mehrlagenleiterplatte nach Anspruch 13, wobei einer der miteinander verbundenen metallischen Bondhügel einen Löttümpel aufweist.

15. Polyimid-Mehrlagenleiterplatte nach Anspruch 13 oder 14, wobei das Lot, aus dem der Löttümpel besteht, das Metall, aus dem der mit dem Löttümpel verbundene metallische Bondhügel besteht, als einen seiner Bestandteile enthält.

16. Polyimid-Mehrlagenleiterplatte nach Anspruch 14 oder 15, wobei der Löttümpel eine plattierte Mehrschichtenstruktur aufweist.

17. Polyimid-Mehrlagenleiterplatte nach Anspruch 14, 15 oder 16, wobei die plattierte Mehrschichtenstruktur abwechselnd angeordnete plattierte Gold- und Zinnschichten aufweist.

18. Polyimid-Mehrlagenleiterplatte nach einem der Ansprüche 14 bis 17, wobei die plattierte Mehrschichtenstruktur abwechselnd angeordnete Zinn- und Bleischichten aufweist.

## Revendications

1. Procédé de fabrication d'une plaquette d'interconnexion multicouche de **polyimide** fournissant des couches de ligne de **polyimide** multiples appliquées sur un substrat plat, comprenant les étapes consistant à :
(a) former un ensemble multicouche de lignes de **polyimide** en prenant un stratifié comprenant une pluralité de couches de ligne sous une forme monobloc sur une feuille plane ;
(b) former un trou d'interconnexion atteignant la couche de ligne intérieure du stratifié, à travers la surface de la couche la plus extérieure dudit bloc;
(c) former un premier sous-ensemble en réalisant une protubérance métallique électriquement reliée à ladite couche de ligne à l'intérieur dudit trou d'interconnexion ;
(d) former un ensemble multicouche de **polyimide** en prenant un stratifié comprenant une pluralité de couches de ligne sous une forme monobloc sur des substrats durcis;
(e) former un trou d'interconnexion atteignant la couche de ligne intérieure du stratifié, à travers la surface de la couche la plus extérieure dudit bloc ;
(f) former un second sous-ensemble en réalisant une protubérance métallique électriquement reliée à ladite couche de ligne à l'intérieur de ladite interconnexion entre couches ;
(g) au moins une de ladite protubérance métallique dudit premier sous-ensemble et de ladite protubérance métallique dudit second sous-ensemble étant réalisé sous la forme de soudure ;
(h) placer lesdits premier et second sous-ensembles l'un sur l'autre de façon à ce que leurs protubérances métalliques viennent en contact réciproque ;
(i) les deux sous-ensembles se chevauchant étant forcés l'un contre l'autre, les chauffer à une température suffisante pour faire fondre lesdites protubérances métalliques puis les refroidir pour raccorder électriquement lesdites protubérances métalliques en contact tout en accouplant les deux blocs ;
(j) retirer ladite feuille plane dudit premier sous-ensemble ;
(k) former un trou d'interconnexion atteignant la couche de ligne interne du stratifié à travers la surface exposée par le retrait de ladite feuille plane ;
(l) répéter lesdites étapes (a) à (c) pour former un autre premier sous-ensemble ;
(m) accoupler l'autre premier sous-ensemble obtenu dans ladite étape **(l)** sur la surface exposée par ladite étape (k) de la même façon que dans lesdites étapes (h) et (i) ; et
(n) répéter lesdites étapes (j) à (m) pour stratifier un nombre désiré de couches linéaires.

2. Procédé selon la revendication 1, dans lequel au moins une desdites protubérances métalliques comprend des couches métallisées multiples chacune réalisée en un métal de soudure.

3. Procédé selon la revendication 1 ou 2 dans lequel ladite multicouche métallisé comporte une couche dorée et une couche étamée alternativement disposées.

4. Procédé selon la revendication 1, 2 ou 3, dans lequel au moins une desdites protubérances métalliques comprend une soudure fondue remplissant ledit trou d'interconnexion.

5. Procédé selon la revendication 4, dans lequel ladite protubérance métallique comporte le même métal que celui constituant ladite soudure fondue ou un alliage contenant ce métal.

6. Procédé selon l'une quelconque des revendications 1 à 5, dans lequel ladite soudure fondue comprend une multicouche métallisée.

7. Procédé selon la revendication 6, dans lequel ladite multicouche métallisée comprend une couche dorée et une couche étamée alternativement disposées.

8. Procédé selon les revendications 6 ou 7, dans lequel ladite multicouche métallisée comporte une couche étamée et une couche plombée alternativement disposées.

9. Procédé selon l'une quelconque des revendications 1 à 8, dans lequel la couche la plus extérieure dudit bloc comporte une résine **polyimide** présentant un point de vitrification et ladite étape (i) est réalisée à une température excédant le point de vitrification de cette résine **polyimide**, de sorte que, par l'auto-adhérence de ladite résine **polyimide**, lesdits blocs sont accouplés.

10. Procédé selon l'une quelconque des revendications 1 à 9 dans lequel l'accouplement desdits blocs dans l'étape (i) est réalisé par un agent adhésif appliqué sur la surface de chacun desdits blocs.

11. Procédé selon la revendication 10, dans lequel ledit agent adhésif comprend un agent adhésif fondu de type dur.

12. Procédé selon la revendication 10, dans lequel ledit agent adhésif comprend un agent adhésif du type fondu.

13. Plaquette d'interconnexion multicouche de **polyimide** fournissant une pluralité de couches de **polyimide** présentant une pluralité de couches de ligne sur leurs deux surfaces sur des substrats, dans laquelle ladite couche de **polyimide** comprend un nombre déterminé de blocs, les couches de ligne de chaque bloc étant électriquement connectées aux couches de ligne d'un autre bloc adjacent par l'intermédiaire d'une pluralité de protubérances métalliques, au moins une des deux protubérances métalliques connectées étant réalisée en soudure.

14. Plaquette d'interconnexion multicouche de **polyimide** selon la revendication 13, dans laquelle une des protubérances métalliques connectées comprend une soudure fondue.

15. Plaquette d'interconnexion multicouche de **polyimide** selon la revendication 13 ou 14, dans laquelle ladite soudure formant la soudure fondue prend le métal formant la protubérance métallique connectée à ladite soudure fondue comme un de ses constituants.

16. Plaquette d'interconnexion multicouche de **polyimide** selon la revendication 14 ou 15, dans laquelle ladite soudure fondue comprend une multicouche métallisée.

17. Plaquette d'interconnexion multicouche de **polyimide** selon la revendication 14, 15 ou 16, dans laquelle ladite multicouche métallisée comprend une couche dorée et une couche étamée alternativement disposées.

18. Plaquette d'interconnexion multicouche de **polyimide** selon une des revendications 14 à 17, dans laquelle ladite multicouche métallisée comprend une couche étamée et une couche plombée alternativement disposées.
